# EUROPEAN PATENT SPECIFICATION

(11) **EP 0 505 652 B1**
(45) Date of publication and mention of the grant of the patent: **13.03.1996**
(21) Application number: 91480052.9
(22) Date of filing: 29.03.1991
(51) Int. Cl.: G06F 11/20

(54) **Memory system with adaptable redundancy**
Speichersystem mit anpassbarer Redundanz
Système de stockage avec redondance adaptable

(43) Date of publication of application: 30.09.1992
(73) Proprietor: INTERNATIONAL BUSINESS MACHINES CORPORATION, Armonk, NY 10504 (US)
(72) Inventor: Bredin, Francis, F-94700 Maisons Alfort (FR); Cantiant, Thierry, F-77190 Dammarie-les-Lys (FR)
(74) Representative: Therias, Philippe

(56) References cited:
- US-A- 3 753 244
- US-A- 4 365 319
- US-A- 4 639 897

## Description

The present invention relates to memory chips and systems in general, and more particularly to a memory system with adaptable redundancy for correcting defective memory cells.

With the size increase of produced memory chips, along with the size decrease of the finest components on each chip, yield has become a major issue to chip manufacturers.

To increase that yield, it has been installed cleaner and vibration-free manufacturing premises, and applied specific mass-production techniques.

For the same purpose, the on-chip redundancy technique has also been used: it consists in developing, implementing and manufacturing on-chip 'extra' circuitry, which is capable of handling some of the functions normally performed by on-chip 'basic' circuitry, if needed. The need arises when it is found out (thru extensive after-manufacturing testing) that part of the basic circuitry is affected by manufacturing defects, and that one or a few functions, that can be isolated from the chip overall functionnality, cannot be performed. The extra circuitry can then be made operational, and functionally replace and correct the defective parts in basic circuitry.

The choice of the amount of implemented extra circuitry is critical: it means chip extra area, when manufacturing yield is clearly depending upon chip overall area. If extra circuitry and area are increased, more defects in the basic circuitry might be corrected, but at the same time, chances are higher that there will be a manufacturing defect within the extra area.

The redundancy technique is well-known in the prior art and can for example be found in US Patent 3,753,244 filed August 18th, 1971, and entitled 'Yield enhancement redundancy technique', or in IBM Technical Disclosure Bulletin, Vol.32, No 8A, Jan 1990, p.75 and 76: 'Redundant/normal clock generation for redundant word line addressing'. The technique is applied there to memory chips and systems which basically feature a memory array, composed of a large plurality of memory cells organized in rows and columns, selectable thru address decoding means either for reading the cell content or for writing it.

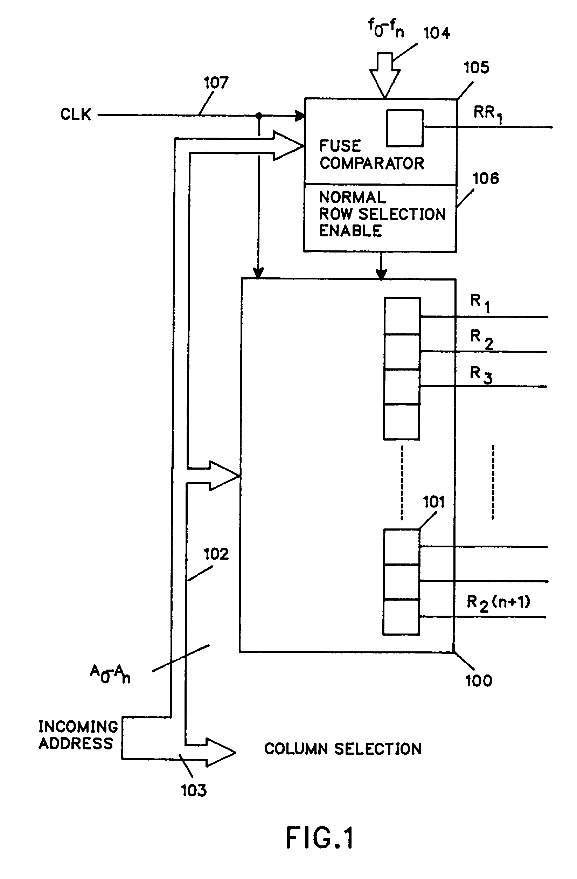

A typical memory system with redundant circuitry as taught by any of the two above cited prior art documents, can be seen FIG.1. The memory array itself is not shown, neither are the address decoding means for the selection of a column in the memory array, according to the binary value of the address incoming on bus 103. But address decoding means (100) for the selection of one of the rows R₁ to R₂(n+1) (n being a positive integer) in the memory array, according to the binary value of address A₀,A₁,...Aₙ incoming on bus 102 can be seen. As is well-known to the man skilled in the art, a row is being selected when an active signal is propagated along a lead corresponding to that row, making it possible to access the memory cells within that row for reading or writing their content. Therefore, the expressions 'select a row' and 'activation signal on lead' will be equally used in the following application, and the reference 'R₁ to R₂(n+1)' will equally apply to both the rows and their corresponding leads.

In block 100 can therefore be identified 2⁽ⁿ⁺¹⁾ identical blocks 101, which constitute the last stage circuit for physically driving the activation signal on one of the leads R₁ to R₂(n+1). This last stage circuit can be quite often a single driver or inverter.

The redundant circuitry is composed of blocks 105 and 106, and their associated input and output signals. A 'FUSE COMPARATOR' 105, is able to select a redundant row RR₁, in the only case when the binary value of address A₀,A₁,...Aₙ on bus 102, matches the binary value provided by fuses f₀,f₁.,...fₙ on bus 104. When at least one memory cell within one of the rows R₁ to R₂(n+1) appears to be defective, the binary value for the address corresponding to that row can be set to the fuses f₀,f₁,...fₙ in a manner well-known to the man skilled in the art ( fuses f₀,f₁,...fₙ can be blown or not to be set to a value '0' or '1', electrically or using a laser, etc...), so that each time an attempt is made to read or write the content of any of the memory cells within that row, it is instead the redundant row which is being selected, and the content of one of the redundant memory cells which is being read or written.

Block 106 'NORMAL ROW SELECTION ENABLE' ensures that there cannot be any simultaneous selection of one of the rows R₁ to R₂(n+1), and the redundant row RR₁.

Signal present on lead 107 'CLK' pulses the whole memory system in a manner also well-known to the man skilled in the art.

Such an implementation of the redundant circuitry however has the main following drawbacks:
- When a redundant access occurs (i.e. the binary value for A₀,A₁,...Aₙ corresponds to the binary value of fuses f₀,f₁,...fₙ), there are two 'racing' parallel active paths in the memory system: one thru blocks 100 and 101, and one thru blocks 105 and 106, and only the signal output by block 106 can prevent the redundant row RR₁ and one of the rows R₁ to R₂(n+1), to be selected at the same time. Therefore, extra care is necessary in the design of blocks 105 and 106, as well as in their layout on a chip, to ensure that the signal output by block 106 will, in any case, be faster that any signal within block 100 that might select one of the rows R₁ to R₂(n+1).
- The layout of blocks 105 and 106 is not repetitive and breaks the regular layout of the memory array (not shown) and decoding circuitry (blocks 100 and 101), but still needs to be optimized so as to require as little chip extra space as possible: the layout is therefore intricately dependent on the choice of implemented redundant circuitry, and cannot be easily adapted to any other circuitry. For example, it cannot be easily provided a second redundant row, in case it appears to be necessary in the chip.
- Moreover, nowadays, memory systems are quite often only sub-parts of a chip; a chip designer picks in a library of available macro functions, a memory system of the desired capacity and organization (number of bits per word). To make those macro functions available, one needs to develop a 'growable' memory system, i.e. a memory system that is easily adjustable to any kind of capacity and organization as required by the chip designer, including an adaptable redundant circuitry, as the amount of needed redundancy clearly evolves with memory system size and organization.

In US-A-4 639 897, a fault tolerant memory system is described, which includes redundant rows to be substituted for defective rows according to priority.

It is therefore an object of the present invention, in accordance with the appended claims, to provide a memory system with adaptable redundancy.

The invention includes a matrix of memory cells, decoding means in each dimension of the matrix for accessing the memory cells, and a part duplicated from a part of the matrix, with an enabling circuitry. The decoding means in a first dimension of the matrix include first means for determining the part of the matrix to be duplicated, and disabling access to the determined part, and second means for enabling access to the duplicate part when the determined part of the matrix is attempted to be accessed, by controlling the enabling circuitry.

Whereby, a memory system with no 'racing' parallel active paths between the selection of 'normal' rows and the selection of redundant rows is provided. The deselection of defective 'normal' rows and the selection of redundant rows is embedded within the mere decoding circuitry of the 'normal' rows, so that the redundancy scheme proposed is easily adaptable to any change in the size and organization of the matrix.

The invention specifically includes circuitry in each last stage circuit meant for physically driving the activation signal on each 'normal' row in the memory array. This circuitry includes a fuse that can be blown to prevent any access to a specific 'normal' row (most likely because a defective memory cell has been detected within that row), and, on an attempt to still access that row, allow the access of a replacing redundant row.

The above introduction had to be read in conjunction with the following schematic:
FIG.1 being a representation of a memory system and its associated redundant circuitry known from the prior art.

The invention will be better understood from the following detailed description read in conjunction with the following schematics:
- FIG.2 showing a representation of a memory system and its associated redundant circuitry according to the present invention.
- FIG.3 showing a detailed view of any block 201 from FIG.2.
- FIG.4 showing a detailed view of block 205 from FIG.2.
- FIG.5 showing a timing diagram in the case of a row of the memory array being selected.
- FIG.6 showing a timing diagram in the case of a redundant row of the memory system being selected.

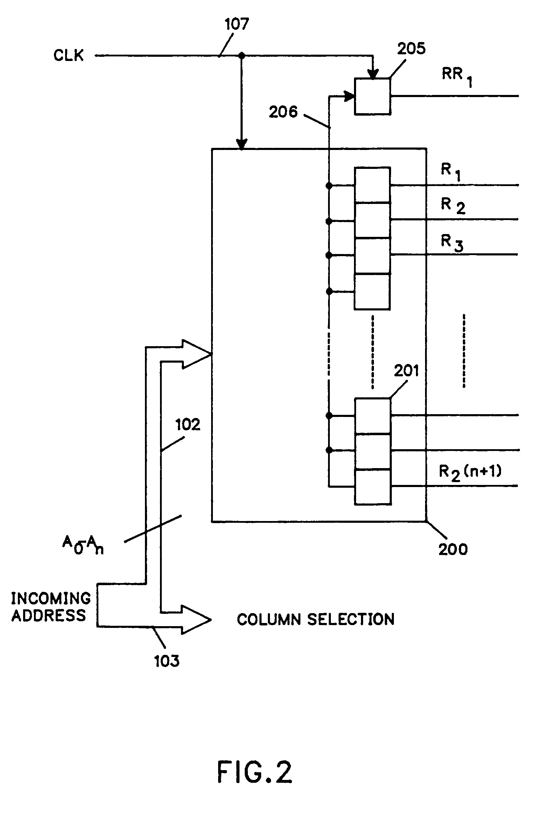

FIG.2 shows a representation of a memory system and its associated redundant circuitry according to the present invention.

Address decoding means (200) for the selection of one of the rows R₁ to R₂(n+1) in the memory array, according to the binary value of address A₀,A₁,... Aₙ incoming on bus 102 can be seen. Block comprises 2⁽ⁿ⁺¹⁾ blocks 201 being able to drive an activation signal on leads R₁ to R₂(n+1), and having an output connected to a lead 206.

Block 205 is able to drive an activation signal on lead RR₁ according to signals present on leads 107 and 206, so as to possibly select redundant row RR₁.

It can be deduced from FIG.2 that, contrary to the well-known redundancy scheme recalled FIG.1, redundancy here is not dependent on the address A₀,A₁,... Aₙ, therefore not on size and organization of the memory array. The grouping (number and position in the array) of rows, one of which being correctable by redundant row RR₁, is free, as long as the last stage driving circuits for these rows share a lead 206, possibly commanding and activation signal on lead RR₁. Several redundant rows can also easily be planned in the memory system, and they introduce very little perturbation in the memory array regular organization.

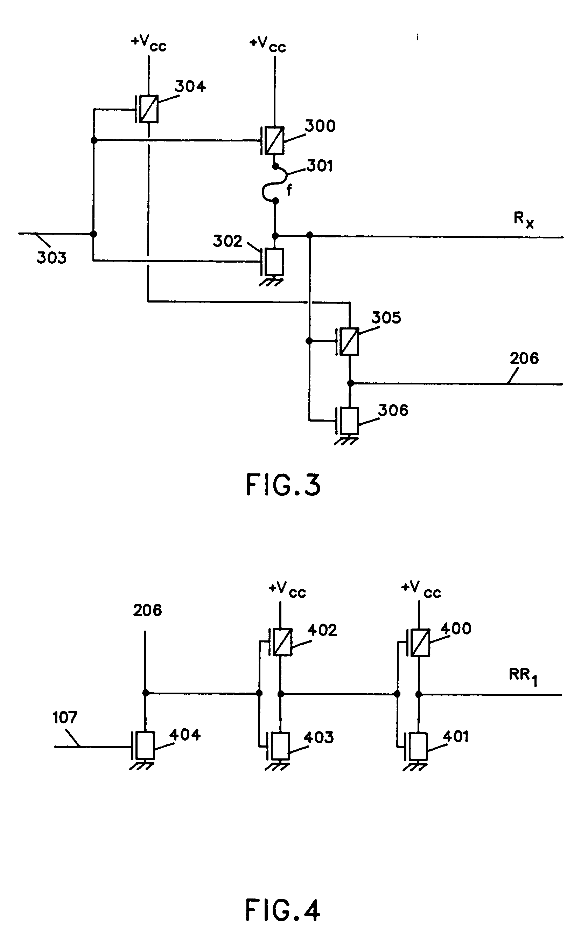

FIG.3 shows a detailed view of any block 201 from FIG.2. while FIG.4 shows a detailed view of block 205. In a preferred embodiment, the invention calls for a Complementary Metal Oxide Semiconductor (CMOS) technology, well-known to the man skilled in the art.

Transistors P-FET (Field Effect Transistor) 300 and N-FET 302 together with fuse 301, provide the driving capability for any of the leads R₁ to R₂(n+1), referenced as Rₓ. Fuse 301 introduces negligible resistance and capacitance (the fuse can be realized in polysilicon, or even better, in small lands of metal) so that a quasi-perfect CMOS inverter is realized, and Rₓ is activated (i.e. its value is equal to a binary '1') if a binary '0' is present on lead 303 (i.e. if the row Rₓ is being attempted to be selected according to the decoding of address A₀,A₁,...Aₙ within block 200).

Transistors P-FET 304, P-FET 305 and N-FET 306 allow the value on lead 206 to be the result of a combination (equivalent to a NOR gate in static combinatory logic) of values on leads 303 and R according to the following table :

| Rx | 303 | 206 |
|---|---|---|
| 1 | - | 0 |
| 0 | 0 | 1 |
| 0 | 1 | 0 |

As leads 303 and Rₓ have opposite values (Cf: inverter 300, 301, 302), the value on lead 206 is always a binary '0', and referring now to FIG.4, the value on lead RR1 can only be a binary '0' whatever the value on lead 107 'CLK': transistors P-FET 400, N-FET 401, P-FET 402 and N-FET 403 providing the driving capability for the lead RR1, realize indeed a non-inverting buffer, so that the value on lead RR₁ is equal to the binary value '0' on lead 206, whatever the value on the gate of transistor N-FET 404.

When a defective memory cell is detected within one of the rows R₁ to R₂(n+1), the fuse 301 in the driver 201 for the lead corresponding to that row is blown. Therefore, and if we refer back to FIG.3, transistors P-FET 300 and N-FET 302 do not realize anymore the previously described inverting function: the value on lead Rₓ can only stick to a binary '0' thru transistor N-FET 302.

According to Table 1, the value on lead 206 is from then on the opposite of the value on lead 303 (the CMOS inverter comprises transistors P-FET 304 and 305, and N-FET 306), so that, if, within block 200, it is attempted to select a row Rₓ according to the decoding of address A,A,...Aₙ, a binary '0' is present on lead 303, but the value on lead 206 rises up to a binary '1', and, providing 107 is low, so does RR1. The redundant row is then selected.

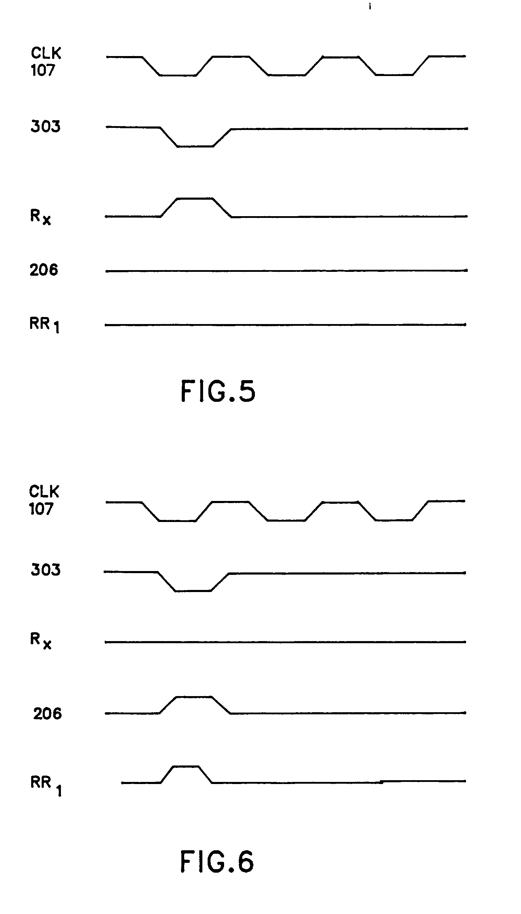

FIG.5 shows a timing diagram in the case of a row of the memory array being selected. There has been no defective cell detected within that row, therefore, the fuse 301 has not been blown, therefore the value on lead Rₓ rises to a binary '1'.

FIG.6 shows a timing diagram in the case of a redundant row of the memory system being selected. There has been a defective cell being detected within that row, therefore, the fuse 301 has been blown, therefore the value on lead Rₓ sticks to a binary '0', but the value on lead RR₁ rises to a binary '1'.

In case of any special requirement that node Rₓ must not be left floating at all (referring to FIG.3 and FIG.6, when fuse 301 is blown, and the row Rₓ is attempted to be selected, i.e. when the value on lead 303 falls to a binary '0', node Rₓ is floating for some time), a conventional latch composed of two cross-coupled inverters can have one of its two nodes connected to node Rₓ (not shown).

Although the invention has been described in a particular embodiment, it will be obvious to the man skilled in the art, that the description is sufficient to allow easy embodiment of the invention in a system manufactured in technologies other than CMOS (for example, MOS or BICMOS), or in a system where the redundancy technique is applied to columns of the memory array, instead of rows.

## Claims

1. A memory system with redundancy, including:
- a two-dimension matrix of memory cells arranged in rows (R1, R2...) and columns,
- decoding means (200) in each dimension of the matrix for accessing said memory cells, and having last stage circuits (101, 201) for respectively driving an activation signal on each of said rows and columns,
- a plurality of redundant rows (RRI) to be substituted for rows including defective memory cells, with an enabling circuitry (205),
- disabling means (301) for disabling access to said rows including defective memory cells,
- enabling means (201, 206) for enabling access to said redundant rows when said rows including defective memory cells are attempted to be accesscd, by controlling said enabling circuit (205),
said memory system being characterized in that
- said disabling and enabling means are located within each of said last stage circuits of said decoding means in a first dimension of said matrix.

2. The system according to claim 1, characterized in that said disabling means include a fuse (301).

3. The system according to claims 1 or 2, characterized in that said enabling means include:
- a first device (304) having its source at a potential Vcc, its gate connected to a lead (303) activated when the defective rows of the matrix are attempted to be accessed, and its drain connected to the source of
- a second device (305) having its gate connected to a lead (Rx) activated when the defective rows of the matrix are accessed, and its drain connected to a lead (206) activated for control ling the enabling circuitry, and to the drain of
- a third device (306) having its gate connected to the lead (Rx) activated when the defective rows of the matrix are accessed, and its source at a ground potential.

4. The system according to anyone of the claims 1 to 3, characterized in that said decoding means in each dimension of the matrix, and said enabling circuitry are pulsed by a system clock (107).

5. The system according to claim 4, characterized in that said enabling circuitry includes:
- a fourth device (404) having its drain at a ground potential, its gate connected to a lead (107) activated by the system clock, and its source connected to the lead (206) activated for controlling said enabling circuitry, and to the gates of
- two devices (402, 403) forming an inverter, the output of which being connected to the gates of two other devices (400, 401) forming another inverter, the output of which being connected to a lead (RRI) enabling access to the duplicate part of the matrix.

## Patentansprüche

1. Speichersystem mit Redundanz, umfassend:
- eine zweidimensionale Matrix von Speicherzellen, die in Zeilen (R1, R2...) und Spalten angeordnet sind,
- Decodiermittel (200) in jeder Dimension der Matrix, um auf die Speicherzellen zuzugreifen, und das Endstufenschaltungen (101, 201) hat, um jede der Zeilen und Spalten mit einem Aktivierungssignal entsprechend anzusteuern,
- eine Vielzahl von redundanten Zeilen (RR1), mit denen Zeilen ersetzt werden sollen, die fehlerhafte Speicherzellen enthalten, mit einer Aktivierungsschaltung (205),
- Deaktivierungsmittel (301) zum Sperren des Zugriffs auf die Zeilen, die fehlerhafte Speicherzellen enthalten,
- Aktivierungsmittel (201, 206) zum Aktivieren des Zugriffs auf die redundanten Zeilen, wenn versucht wird, auf die fehlerhafte Speicherzellen enthaltenden Zeilen zuzugreifen, indem die Aktivierungsschaltung (205) gesteuert wird,
wobei das Speichersystem dadurch gekennzeichnet ist, daß
- die Deaktivierungs- und Aktivierungsmittel innerhalb jeder der Endstufenschaltungen des Decodiermittels in einer ersten Dimension der Matrix angeordnet sind.

2. System gemäß Anspruch 1, dadurch gekennzeichnet, daß die Deaktivierungsmittel eine Sicherung (301) enthalten.

3. System gemäß Ansprüchen 1 oder 2, dadurch gekennzeichnet, daß die Aktivierungsmittel umfassen:
- ein erstes Bauelement (304), das seine Quelle bei einem Potential Vcc hat, dessen Gate mit einer Anschlußleitung (303) verbunden ist, die aktiviert wird, wenn versucht wird, auf die fehlerhaften Zeilen der Matrix zuzugreifen, und dessen Senke verbunden ist mit der Quelle eines
- zweiten Bauelementes (305), dessen Gate mit einer Anschlußleitung (Rx) verbunden ist, die aktiviert wird, wenn auf die fehlerhaften Zeilen zugegriffen wird, und dessen Senke mit einer Anschlußleitung (206) verbunden ist, die zur Steuerung der Aktivierungsschaltung aktiviert wird, und mit der Senke
- eines dritten Bauelementes (306) verbunden ist, dessen Gate mit der Anschlußleitung (Rx) verbunden ist, die aktiviert wird, wenn auf die fehlerhaften Zeilen der Matrix zugegriffen wird, und dessen Quelle auf Massepotential liegt.

4. System gemäß einem beliebigen der Ansprüche 1 bis 3, dadurch gekennzeichnet, daß das Decodiermittel in jeder Dimension der Matrix und die Aktivierungsschaltung durch einen Systemtaktgeber (107) gepulst werden.

5. System gemäß Anspruch 4, dadurch gekennzeichnet, daß die Aktivierungsschaltung umfaßt:
- ein viertes Bauelement (404), das seine Senke auf Massepotential hat, wobei sein Gate mit einer Anschlußleitung (107) verbunden ist, die durch den Systemtaktgeber aktiviert wird, und dessen Quelle mit der Anschlußleitung (206) verbunden ist, die zur Steuerung der Aktivierungsschaltung aktiviert wird, und mit den Gates von
- zwei Bauelementen (402, 403) verbunden ist, die eine Umkehrstufe bilden, deren Ausgang mit den Gates zweier anderer Bauelemente (400, 401) verbunden ist, die eine weitere Umkehrstufe bilden, deren Ausgang mit einer Anschlußleitung (RR1) verbunden ist, die Zugriff auf den duplizierten Teil der Matrix gewährt.

## Revendications

1. Système de mémoire avec redondance, comprenant :
- une matrice bidimensionnelle de cellules mémoire agencées en lignes (R1, R2 ...) et en colonnes,
- un moyen de décodage (200) suivant chaque dimension de la matrice afin d'accéder auxdites cellules mémoire et comportant des circuits de dernier étage (101, 201) destinés à attaquer au moyen d'un signal d'activation chacune desdites lignes et colonnes,
- une pluralité de lignes redondantes (RR1) destinées à remplacer des lignes qui comportent des cellules mémoire défectueuses, avec des circuits de validation (205),
- un moyen d'invalidation (301) destiné à invalider l'accès auxdites lignes comportant des cellules mémoire défectueuses,
- des moyens de validation (201, 206) destinés à valider l'accès auxdites lignes redondantes lorsque l'on tente d'accéder auxdites lignes comportant des cellules mémoire défectueuses, en commandant ledit circuit de validation (205),
ledit système de mémoire étant caractérisé en ce que
- lesdits moyens d'invalidation et de validation sont situés à l'intérieur de chacun desdits circuits de dernier étage dudit moyen de décodage suivant une première dimension de ladite matrice.

2. Système selon la revendication 1, caractérisé en ce que ledit moyen d'invalidation comprend un fusible (301).

3. Système selon les revendications 1 ou 2, caractérisé en ce que ledit moyen de validation comprend :
- un premier dispositif (304) ayant sa source à un potentiel Vcc, sa grille étant reliée à un conducteur (303) activé lorsque l'on tente d'accéder aux lignes défectueuses de la matrice, et son drain relié à la source de
- un second dispositif (305) ayant sa grille reliée à un conducteur (Rx) activé lorsque l'on accède aux lignes défectueuses de la matrice, et son drain relié à un conducteur (206) activé afin de commander les circuits de validation, et au drain de
- un troisième dispositif (306) ayant sa grille reliée au conducteur (Rx) activé lorsque l'on accède aux lignes défectueuses de la matrice, et sa source à un potentiel de masse.

4. Système selon l'une quelconque des revendications 1 à 3, caractérisé en ce que ledit moyen de décodage suivant chaque dimension de la matrice et lesdits circuits de validation reçoivent des impulsions d'une horloge système (107).

5. Système selon la revendication 4 caractérisé en ce que lesdits circuits de validation comprennent :
- un quatrième dispositif (404) ayant son drain à un potentiel de masse, sa grille reliée à un conducteur (107) activé par l'horloge système et sa source reliée au conducteur (206) activé afin de commander lesdits circuits de validation et aux grilles de
- deux dispositifs (402, 403) formant un inverseur, dont la sortie est reliée aux grilles de deux autres dispositifs (400, 401) formant un autre inverseur, dont la sortie est reliée à un conducteur (RR1) validant l'accès à la partie dupliquée de la matrice.
